# EUROPEAN PATENT SPECIFICATION

(11) **EP 2 900 046 B1**
(45) Date of publication and mention of the grant of the patent: **14.08.2019**
(21) Application number: 14152849.7
(22) Date of filing: 28.01.2014
(51) Int. Cl.: H05K 7/20

(54) **Arrangement and method for subsea cooling of electronics equipment**
Anordnung und Verfahren für eine Unterwasserkühlung von elektronischen Geräten
Agencement et procédé pour refroidissement sous-marin d'équipement électronique

(43) Date of publication of application: 29.07.2015
(73) Proprietor: ABB Schweiz AG, 5400 Baden (CH)
(72) Inventor: Gradinger, Thomas, CH-5032 Aarau Rohr (CH); Laneryd, Tor, SE-722 18 Västerås (SE); Wagner, Thomas, CH-5506 Mägenwil (CH)
(74) Representative: Savela, Reino Aleksi

(56) References cited:
- EP-A1- 2 487 327
- US-A1- 2010 139 544

## Description

### TECHNICAL FIELD

The invention relates to cooling arrangements, and particularly to arrangements and methods for subsea cooling of electronics equipment, and to a subsea power conversion unit comprising such an arrangement.

### BACKGROUND

In general terms, electric subsea installations and devices usually demand high standards regarding durability, long-term functionality and independence during operation. Electric subsea installations that need to be cooled during operation, such as subsea converters, require an autonomous and durable cooling of its components. It is known to use a dielectric liquid such as a for example oil as a cooling fluid. In general, electric subsea installations need to be pressurized with the dielectric fluid, thus said fluid, which is preferably a liquid, should be, at least almost, incompressible. In general terms, the dielectric liquid thus is used to provide an incompressible medium and additionally as an electric insulation medium of components, such as power electronics building blocks (PEBBs), placed in the electric installation.

The oil may thus be used both for the cooling of the electric and electronic components of the subsea converter, and for the electric insulation. Because of the high reliability required, the subsea converter cooling system may be passive, i.e., without the need for a pump to achieve the cooling. The oil in the converter tank (and in any oil-to-sea-water heat exchanger) may thus be moved by natural convection only. Also the sea water cooling the oil-to-sea-water heat exchanger may be moved by natural convection only. Consequently, the cooling efficiency is limited, and the design of an economical cooling system may be challenging.

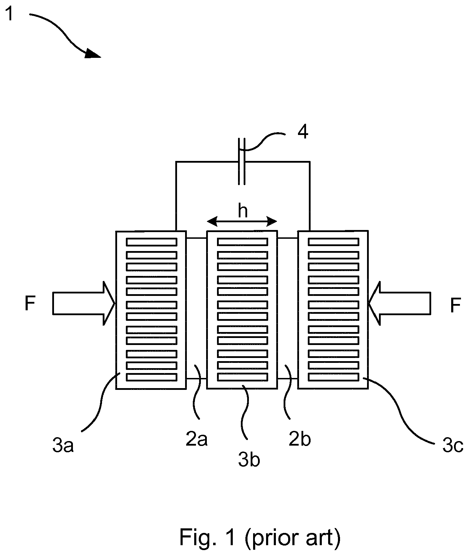

Figure 1 is a top view schematically illustrating a known arrangement 1 for cooling components, such as semiconductor modules 2a, 2b, of a subsea converter consisting of heat sinks 3a, 3b, 3c that are attached to the semiconductor modules. The heat sinks 3a, 3b, 3c have thickness h. The semiconductor modules 2a, 2b and heat sinks 3a, 3b, 3c are surrounded by dielectric fluid (not shown in Figure 1), electrically insulating the semiconductors and heat sinks from the grounded tank wall (not shown in Figure 1) of the subsea converter.

According to this arrangement the dielectric fluid flows through the heat sinks 2a, 2b, 2c in an upward direction, taking up the heat produced by the semiconductor modules. Dielectric fluid heated by the heat sinks is collected at the top of the tank, and passed into an external heat exchanger which is cooled by sea water. Cold dielectric fluid then thus returns from the sea-water heat exchanger to the bottom of the tank before it again flows through the heat sinks of the semiconductor modules. The whole cycle is driven by natural convection.

The semiconductor modules 2a, 2b may be clamped to heat sinks on both sides (one side being the emitter side, the other side being the collector side of the semiconductor modules 2a, 2b. Further, a capacitor 4 is coupled between the semiconductor module 2a and the semiconductor module 2b). The arrangement 1 may be kept together by clamping forces F being applied to the heat sink 3a and the heat sink 3c. The semiconductor modules 2a, 2b of a converter cell may hence be sandwiched between three heat sinks (in the order: heat sink / semiconductor module / heat sink / semiconductor module / heat sink).

One problem is posed by the relatively large thickness h of the middle heat sink 3b. To achieve sufficient cooling performance, the fins of this heat sink 3b must have a minimum length. Both fin length and base-plate thickness of the heat sink 3b contribute to h.

In general terms, stray inductance is unintended and unwanted inductance in an electrical circuit. Inductance does not exist only within inductors; any wires or component leads that have current flowing through them create magnetic fields. When these magnetic fields are created, they can produce an inductive effect. Thus, wires or components leads can act as inductors if they are long enough. Such effects are often present within circuits (for example, between conductive runs of wire traces or components with long leads such as capacitors), even though they are not intended. This unintended inductance is referred to as stray inductance, and it can result in a disruption of normal current flow within a circuit. In the arrangement of Figure 1, two semiconductor modules 2a, 2b and one capacitor 4 form a so-called converter cell. The two semiconductor modules 2a, 2b and the capacitor 4 form a commutation loop, that thus should have as low an inductance as possible, to limit semiconductor stresses and switching losses.

EP 2 487 327 discloses a subsea electronic system. The system comprises a water tight enclosure adapted to enable an operation of the system under water. A heat generating electronic component is arranged in the enclosure. The electronic component generates heat in operation. The enclosure is at least partially filled with a dielectric liquid in which the electronic component is at least partially submerged. A heat sink is arranged on a wall of the enclosure and thermally coupled thereto.

US 2010/139544 relates to a Variable Speed Drive or subsea installations, subsea vessels or subsea vehicles, as well as to a corresponding subsea installation, subsea vessel or subsea vehicle, has an alternating current/alternating current converter having a current-controlled capacitor-less direct current link.

One challenge is thus how to reduce the inductive losses in such arrangements.

Hence there is still a need for improved cooling of electronic equipment in subsea applications.

### SUMMARY

An object of embodiments herein is to provide improved mechanisms for subsea cooling of electronic equipment in subsea applications.

A particular object of embodiments herein is to provide improved mechanisms for subsea cooling of electronic equipment in subsea applications having small inductive losses. The inventors have realized that from an electrical point of view, the distance h should thus be as small as possible to minimize the stray inductance of the commutation loop (i.e., in the arrangement 1 of Figure 1 the first heat sink 3a and the third heat sink 3c should be as close together as possible).The inventors have realized that the inductive losses may be reduced if the distance h is reduced.

The present invention addresses this by means of an arrangement based on heat pipes which may be used to transfer heat away from semiconductor modules.

Particularly, according to a first aspect there is presented an arrangement for subsea cooling of a semiconductor module. The arrangement comprises a tank, the tank being filled with a dielectric fluid, the dielectric fluid being a liquid. The arrangement comprises a semiconductor module, the semiconductor module being provided in the tank. The arrangement comprises a thermally conductive block, the thermally conductive block being provided in the tank and in thermal contact with the semiconductor module so as to enable heat to be transferred from the semiconductor module to the thermally conductive block. The arrangement comprises a heat pipe, the heat pipe being at least partly embedded in the thermally conductive block so as to transfer heat away from the thermally conductive block.

Advantageously, this enables heat pipes to be embedded in bores of a thermally conductive block.

Advantageously, this enables heat pipes to be used for heat transfer from a thermally conductive block in a unit comprising the thermally conductive block and a semiconductor module to the dielectric fluid. Advantageously this arrangement enables the inductive losses to be reduced.

Advantageously, this enables heat pipes to be used to spread heat to the tank wall in case of direct seawater cooling, i.e., cooling where seawater acts as the cooling means.

Advantageously, this enables heat pipes to be used in feasible operations under 300 bar ambient pressure with reasonable wall thicknesses according to considerations made for thermo-mechanical reasons.

Advantageously, heat pipes with circular cross-sectional areas may be used because such heat pipes have a higher resistance to ambient pressure than flat heat pipes.

According to a second aspect there is presented a subsea power conversion unit comprising an arrangement according to the first aspect.

According to a third aspect there is presented a method for subsea cooling of a semiconductor module. The method comprises providing a tank filled with a dielectric fluid. The method comprises providing a semiconductor module in the tank. The method comprises providing a thermally conductive block in the tank to be in thermal contact with the semiconductor module so as to enable heat to be transferred from the semiconductor module to the thermally conductive block. The method comprises providing a heat pipe at least partly embedded in the thermally conductive block. The method comprises cooling the semiconductor module by transferring heat away from the thermally conductive block through the heat pipe.

It is to be noted that any feature of the first, second and third aspects may be applied to any other aspect, wherever appropriate. Likewise, any advantage of the first aspect may equally apply to the second, and/or third aspect, respectively, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Figure 1 schematically illustrates an arrangement for cooling semiconductor modules according to prior art;
Figures 2 to 8 schematically illustrate arrangements for cooling semiconductor modules according to embodiments; and
Fig 9 schematically illustrates a heat pipe; and
Figure 10 is a flow chart illustrating a method according to an embodiment.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

Cooling systems for electric equipment, and specifically for electric subsea converters, are used to cool down electric components, such as semiconductor modules, connectors and capacitors. These components generate heat that needs to be dissipated by the cooling system. The cooling systems of subsea converters are usually designed in a simple manner avoiding any unnecessary parts and mechanisms. Generally it is desirable to have passive cooling systems, thus cooling systems without any driven or powered parts, such as for example without pumps, to cool down the electric components. In some cases natural convection is used. Natural convection helps to avoid the use of a pump but it has a low efficiency. Cooling by natural convection uses the heat transfer from the cooling liquid to the surrounding sea water to generate circulation within the cooling system and thus within the electric installation and the subsea converter. In some cases some kind of a heat exchanger is used to transfer heat from the cooling liquid to the sea water.

According to a first, general embodiment of the present invention, heat pipes are used to transfer the heat away from semiconductor modules.

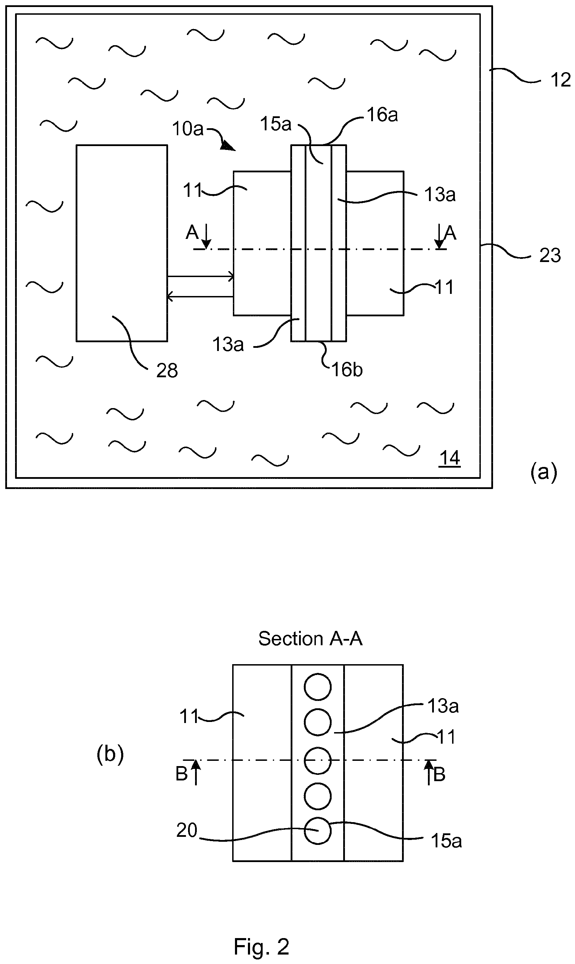

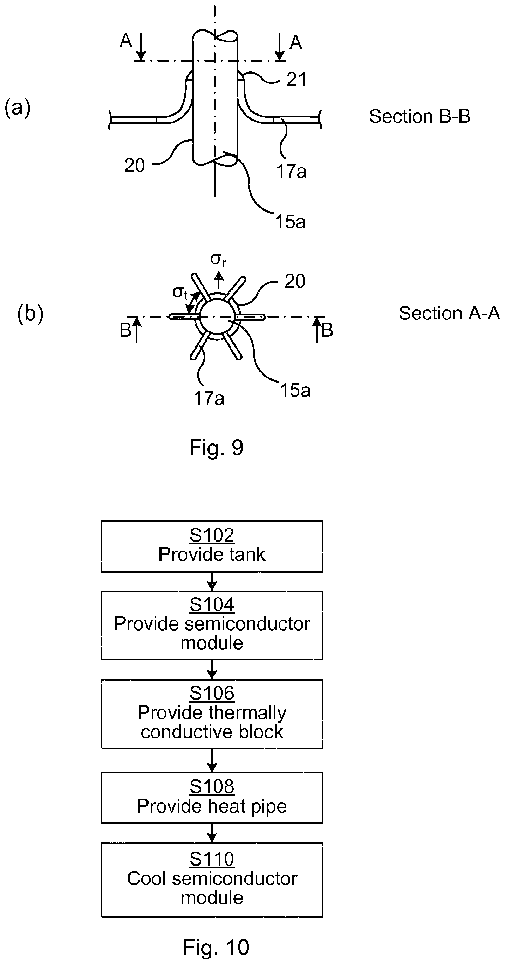

Reference is now made to Figure 2. Figure 2(a) is a cross-sectional top view illustrating a vertically arranged arrangement 10a for subsea cooling of at least one semiconductor module 11 according to an embodiment. Parallel reference is made to Figure 10 being a flow chart illustrating a method for subsea cooling of a semiconductor module 11 according to an embodiment. The arrangement 10a is schematically illustrated as being part of a subsea power conversion unit 28. Figure 2(b) is a cross-sectional side view taken at the section A-A in Figure 2(a). One example of semiconductor modules is insulated gate bipolar transistor (IGBT) modules. They can be arranged in units such as press packs, i.e., sandwiched between cooling elements, such as heat sinks or other forms of cooler and clamped together with the cooling elements to achieve good electric and thermal contact. The arrangement 10a comprises a tank 12. The tank 12 is filled with a dielectric fluid 14. The method for cooling a semiconductor module 11 thus comprises, in a step S102, providing a tank 12 filled with a dielectric fluid 14. The dielectric fluid 14 may circulate inside the tank 12 due to natural convection. The arrangement 10a further comprises at least one semiconductor module 11. The method for cooling a semiconductor module 11 thus comprises, in a step S104, providing a semiconductor module 11 in the tank 12. The semiconductor module 11 may be part of a power electronics building block. The at least one semiconductor module 11 is provided in the tank 12. In general terms, the arrangement 10a may comprise a plurality of semiconductor modules 11 provided in the tank 12.

In use each semiconductor module 11 generates heat. In order to provide cooling of the semiconductor module(s) 11 there is provided a thermally conductive block 13a. The arrangement 10a thus further comprises a thermally conductive block 13a. The method for cooling a semiconductor module 11 thus comprises, in a step S106, providing a thermally conductive block 13a in the tank 12. The thermally conductive block 13a is provided in the tank 12 and is in thermal contact with the semiconductor module 11. The thermally conductive block 13a thereby enables heat to be transferred from the semiconductor module 11 to the thermally conductive block 13a.

The arrangement 10a further comprises a heat pipe 15a. The method for cooling a semiconductor module 13a thus comprises, in a step S108, providing a heat pipe 15a at least partly embedded in the thermally conductive block 13a. The heat pipe 15a is at least partly embedded in the thermally conductive block 13a so as to transfer heat away from the thermally conductive block 13a. The method for cooling a semiconductor module 11 thus comprises, in a step S110, cooling the semiconductor module 11 by transferring heat away from the thermally conductive block 13a through the heat pipe 15a.

As will be further disclosed below, heat may thereby be transferred to the dielectric fluid 14 (thus causing the dielectric fluid 14 to circulate in the tank 12 due to natural convection) and/or to the wall of the tank 12. For example, as illustrated in the cross-sectional view taken at the section A-A of the arrangement 10a, the thermally conductive block 13a comprises at least one bore hole as defined by bore hole walls 20. The at least one bore hole thus defines a cavity, or void, in which a heat pipe 15a may reside. As the skilled person understands the thermally conductive block 13a may comprise a plurality of bore holes.

The heat pipe 15a may be used to reduce the thickness h of the second heat sink 3b shown in Figure 1. Instead of a heat sink with fins (as in the arrangement 1 of Figure 1), only a plate or block 13a with embedded heat pipes 15a may thus be clamped between the semiconductor modules 11. These plates or blocks would be typically made from aluminum. While preliminary calculations suggested a necessary thickness h of about 60 mm for the second heat sink 3b of the arrangement 1, a plate or block 13a with embedded heat pipes 15a as herein disclosed could be realized with a thickness of 20 mm or less. The reduced stray inductance of the commutation loop as defined by the capacitor coupling between the semiconductor modules 2a and 2c in the arrangement 1 can help to avoid a clamping circuit being added to the semiconductor modules. Such a clamping circuit can be used to mitigate the adverse effects of the stray inductance of the commutation loop, but has its own disadvantages.

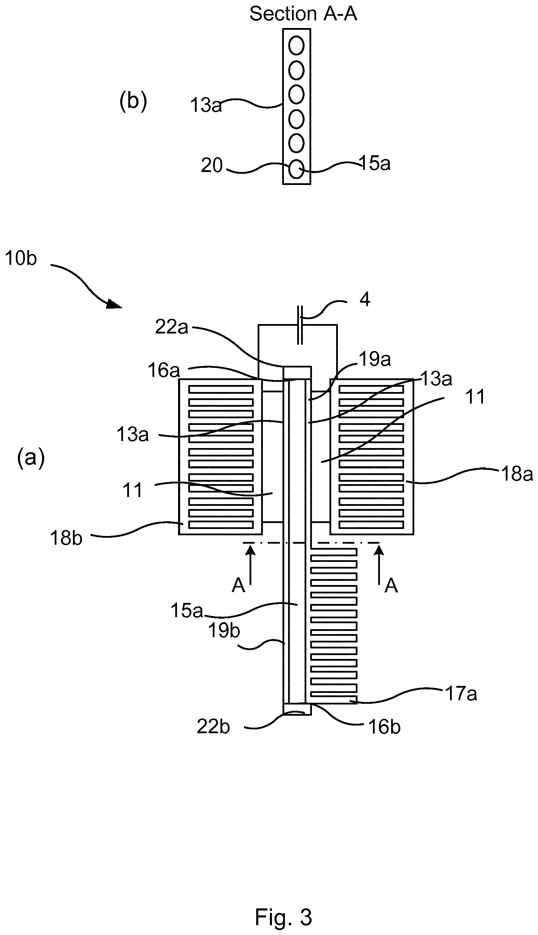

As noted above, the herein disclosed arrangements for cooling semiconductor modules may be part of a subsea power conversion unit 28. Hence, a subsea power conversion unit 28 may comprise any of the herein disclosed arrangements for cooling semiconductor modules 11. The tank 12 may thus be a water-sealed tank. A particular difficulty in subsea applications is the high ambient pressure of up to 300 bar of the sea water. To avoid thick tank walls, the dielectric fluid 14 in the subsea power conversion unit 28 is also kept at ambient pressure. Thus, the dielectric fluid 14 may be pressurized to a pressure closer to ambient sea water pressure than to atmospheric pressure. In a heat pipe 15a, the heat transfer may be facilitated by the circulation of a two-phase fluid which is at a pressure near 1 bar (from below 1 bar to maximally several tens of bars, depending on the type of fluid and the temperature). For example a heat pipe which is hermetically sealed at each end and so may contain a two-phase fluid is described below on page 10 in reference to Figure 3a. The pressure inside the heat pipe 15a may hence be small compared to the maximum possible pressure of the surrounding dielectric fluid 14. As a first approximation, it may be assumed that the pressure in the heat pipe 15a is zero and an outer overpressure corresponding to the full ambient pressure must be withstood by the heat pipe wall. As a consequence, the heat-pipe wall thickness should be large enough to yield sufficient mechanical strength and stability (the latter to avoid buckling).

If a heat pipe 15a is embedded in a bore of a thermally conductive block 13a, the dielectric fluid 14 may creep into the radial boundary between heat pipe 15a and the bore surface, such that the entire heat pipe 15a is exposed to the full pressure of the dielectric fluid 14 on the outside. As a consequence thereof, a radial gap, filled with dielectric fluid 14, may open between the heat pipe 15a and the bore surface, adding additional thermal resistance.

The heat pipe may be mechanically compressed by the dielectric fluid 14 which is under high pressure, such that a gap opens between the heat pipe 15a and the wall of the bore in the thermally conductive block 13a in which the heat pipe is embedded. This thermal resistance can be kept small enough by providing a sufficient heat-pipe wall thickness, such as 2 mm.

Further, heat pipes with a circular cross-section may be used to handle the high external pressure around the heat pipe. Heat pipes with non-circular cross-section may more easily collapse due to external pressure. This means that embedding heat pipes in grooves in heat sinks may be disadvantageous for the present application since such heat pipes are pressed flat, and are hence not circular.

Embodiments relating to further details of the arrangement for cooling a semiconductor module will now be disclosed.

According to a second embodiment, for transferring the heat to the dielectric fluid 14, fins 17a may be attached to the plate or block 13a with embedded heat pipes 15a. Such an arrangement 10b for cooling semiconductor modules 11 is illustrated in Figure 3. Figure 3(a) is a top view illustrating a vertically arranged arrangement 10b for cooling at least one semiconductor module 11 according to an embodiment. Figure 3(b) is a cross-sectional side view taken at the section A-A in Figure 3(a). In addition to the arrangement 10a of Figure 2, the arrangement 10b of Figure 3 thus further comprises heat sinks 18a, 18b, a capacitor 4, and fins 17a.

According to a third embodiment, high external pressure around the heat pipe 15a and the consequent radial gap between the heat pipe 15a and bore wall 20 of the heat pipe 15a are avoided by completely enclosing the heat pipe 15a in the thermally conductive block 13a. The heat pipe may for example extend between a first end 16a and a second end 16b, and the first end 16a and the second end 16b may be hermetically closed. For example, bars 22a, 22b (such as in the arrangement 10b of Figure 3) may be welded to the end faces of the thermally conductive block 13a, thereby hermetically closing the bore holes 20 of the heat pipe 15a. Thus, the inside of the bore holes 20 may remain under near-atmospheric pressure, and the opening of a radial gap between heat pipe 12 and bore surface due to heat pipe compression is avoided.

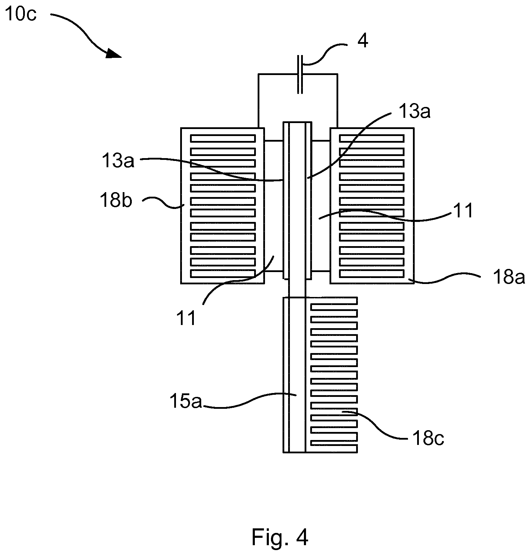

According to a fourth embodiment, the heat pipes 15a are not completely enclosed in the thermally conductive block 13a, but lead from the thermally conductive block 13a, which may be clamped between the semiconductor modules 11, to a heat sink 18c for heat transfer to the dielectric fluid 14. Such an arrangement 10c is shown in Figure 4. Figure 4 is a top view illustrating a vertically arranged arrangement 10c for cooling at least one semiconductor module 11 according to an embodiment. Thus, according to an embodiment the arrangement 10c for cooling a semiconductor module 11 comprises at least one heat sink 18a, 18b, 18c and where a first end of the heat pipe 15a is embedded in the thermally conductive block 13a, and a second end of the heat pipe 15a is embedded in the heat sink 18c for heat transfer to the dielectric fluid 14.

Alternatively, a first portion 19a of the thermally conductive block 13a is arranged to be in thermal contact with the semiconductor module 11 and to receive heat from the semiconductor module 11, and a second portion 19b of the thermally conductive 13a block is arranged to be in thermal contact with the dielectric fluid 14 so as to transfer heat to the dielectric fluid. For example, the second portion of the thermally conductive block 13a may have an extended surface for transferring heat to the dielectric fluid 14. The extended surface may comprise a set of fins.

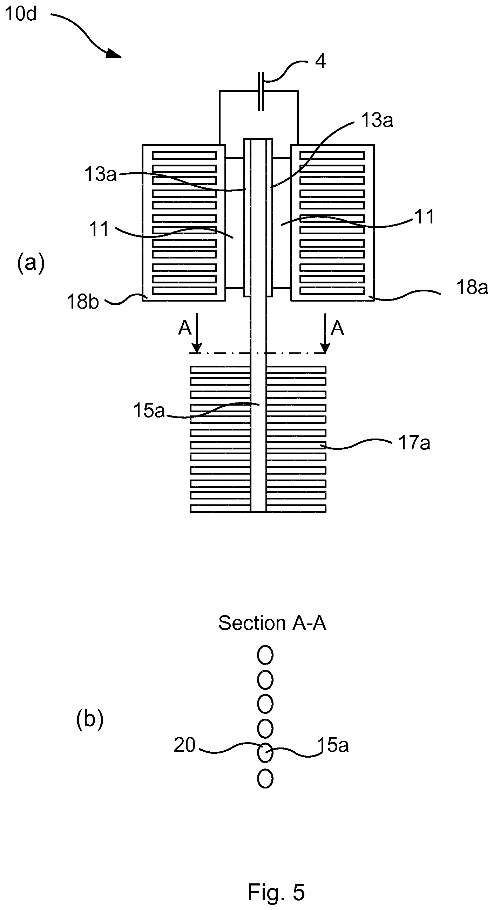

According to a fifth embodiment, the heat sink for transferring heat to the dielectric fluid 14 consists of metal sheets. The heat pipe 15a may then be provided through holes in the metal sheets and may be brazed to the metal sheets to ensure good thermal contact. Such an arrangement 10d is illustrated in Figure 5. Figure 5(a) is a top view illustrating a vertically arranged arrangement 10d for cooling at least one semiconductor module 11 according to an embodiment. Figure 5(b) is a cross-sectional side view taken at the section A-A in Figure 5(a). Hence, a first end of the heat pipe 15a may be embedded in the thermally conductive block 13a and a second end of the heat pipe 15a may comprise a set of fins 17a for heat transfer to the dielectric fluid 14.

If the heat pipe 15a shrinks in radius due to external pressure, tension may be created in the brazed joint 21 between heat pipe 15a and fins 17a. To reduce this tension, the fins 17a may be rounded at the hole and radial slits may be added, as illustrated in Figure 9. Figure 9(a) is a cross-sectional view illustrating a heat pipe 15a with fins 17a according to an embodiment. Figure 9(b) is a cross-sectional view taken at the section A-A in Figure 9(a). Figure 9 schematically illustrates rounding and slitting of holes in the fins 17a to reduce stress σᵣ and σₜ in connection with a heat pipe 15a if the heat pipe 15a shrinks due to external pressure, where σᵣ is the radial tension on the brazing and σₜ is the tangential tension on the brazing. According to the example of Fig 9 there are six fins 17a.

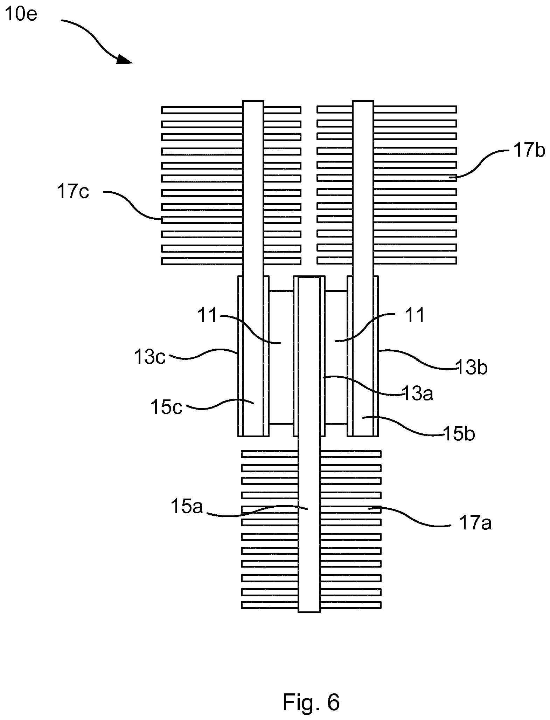

According to a sixth embodiment, heat pipes are not only used instead of one heat sink, instead of at least two heat sinks, preferably all heat sinks, in the semiconductor module 11. Such an arrangement 10e is illustrated in Figure 6. Figure 6 is a top view illustrating a vertically arranged arrangement 10e for cooling at least one semiconductor module 11 according to an embodiment. The arrangement 10e may thus comprise at least one further heat pipe 15b, 15c. The at least one further heat pipe 15b, 15c may be at least partly embedded in a respective thermally conductive block 13b, 13c so as to transfer heat away from its thermally conductive block 13b, 13c. The ends of the heat pipes 15a, 15b, 15c not embedded in thermally conductive blocks 13a, 13b, 13c may comprise respective fins 17a, 17b, 17c.

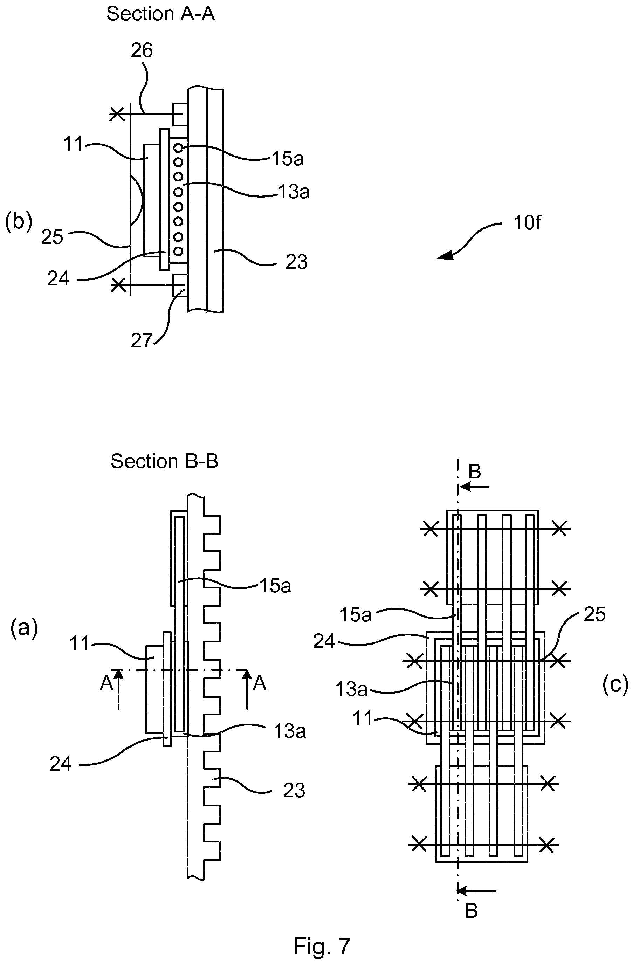

According to a seventh embodiment, heat pipes 15a, 15b, 15c are used to spread the heat from the semiconductor modules 11 to the tank wall 23, as shown in Figure 7. Figure 7(a) is a cross-sectional top view illustrating an arrangement 10f for cooling at least one semiconductor module 11 according to an embodiment. Figure 7(b) is a cross-sectional side view taken at the section A-A in Figure 7(a). Figure 7(c) is a side view of the arrangement 10f as seen from inside the tank 12. Figure 7 schematically illustrates an arrangement 10f which in relation to the arrangement 10a of Figure 2 further comprises an electrically insulating plate 24. The electrically insulating plate 24 is sandwiched between the thermally conductive block 13a and the semiconductor module 11. The semiconductor module 11 may be clamped to the tank wall 23 by means of a clamping yoke 25, clamping rods 26, and studs 27 welded to the tank wall 23.

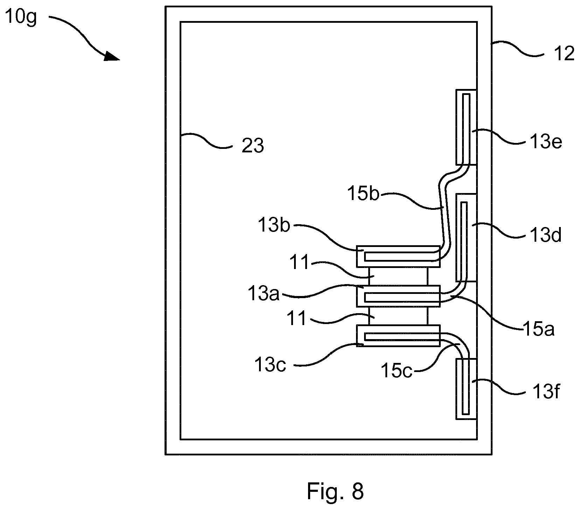

According to an eighth embodiment, heat pipes 15a, 15b, 15c are used to spread the heat from the semiconductor modules to the tank wall 23, avoiding mechanically clamping semiconductors to the tank wall 23. According to this embodiment the clamping force of the semiconductor modules 11 and thermally conductive blocks 13a, 13b, 13c is not transmitted to the tank wall 23. Figure 8 is a top view illustrating an arrangement 10g for cooling at least one semiconductor module 11 according to an embodiment. Figure 8 schematically illustrates an arrangement 10g which in relation to the arrangement 10a of Figure 2 comprises three heat pipes 15a, 15b, 15c, each having a first end embedded in a first thermally conductive block 13a, 13b, 13c and a second end embedded in a second thermally conductive block 13d, 13e, 13f, such as a plate. Hence, a first end of the heat pipe 15a may be embedded in a first thermally conductive block 13a, and a second end of the heat pipe 15a may be embedded in a second (further) thermally conductive block 13d for heat transfer to the wall 23 of the tank 12. The second thermally conductive blocks 13d, 13e, 13f into which one end of the heat pipes 15a, 15b, 15c are embedded may be clamped to the tank wall 23 with significantly lower force than is necessary for clamping the thermally conductive blocks 13a, 13b, 13c to the semiconductor modules 11.

The invention has mainly been described above with reference to a few embodiments. However, as is readily appreciated by a person skilled in the art, other embodiments than the ones disclosed above are equally possible within the scope of the invention, as defined by the appended patent claims. Further, as the skilled person understands, any feature associated with the herein disclosed arrangements for cooling a semiconductor module may also be associated with the herein disclosed method for cooling a semiconductor module, where terms such as "comprising", "including", etc., may be replaced by the term "providing", etc.

## Claims

1. An arrangement (10a, 10b, 10c, 10d, 10e, 10f, 10g) for subsea cooling of a semiconductor module (11), the arrangement comprising:
a tank (12), the tank being filled with a dielectric fluid (14), the dielectric fluid being a liquid;
a semiconductor module (11), the semiconductor module being provided in the tank; **characterized by**
a thermally conductive block (13a), the thermally conductive block being provided in the tank and in thermal contact with the semiconductor module so as to enable heat to be transferred from the semiconductor module to the thermally conductive block; and
a heat pipe (15a), the heat pipe being at least partly embedded in the thermally conductive block so as to transfer heat away from the thermally conductive block.

2. The arrangement according to claim 1, wherein the heat pipe extends between a first end (16a) and a second end (16b), and
wherein the first end and the second end are hermetically closed in the thermally conductive block.

3. The arrangement according to claim 1, wherein the thermally conductive block has a first portion (19a) and a second portion (19b),
wherein the first portion of the thermally conductive block is arranged to be in thermal contact with the semiconductor module and to receive heat from the semiconductor module; and
wherein the second portion of the thermally conductive block is arranged to be in thermal contact with the dielectric fluid so as to transfer heat to the dielectric fluid.

4. The arrangement according to claim 3,
wherein the second portion of the thermally conductive block has an extended surface for transferring heat to the dielectric fluid.

5. The arrangement according to claim 4,
wherein the extended surface comprises a set of fins (17a, 17b, 17c).

6. The arrangement according to claim 1, further comprising
a heat sink (18a, 18b); and
wherein the heat pipe extends between a first end (16a) and a second end (16b),
wherein the first end of the heat pipe is embedded in the thermally conductive block, and
wherein the second end of the heat pipe is embedded in the heat sink for heat transfer to the dielectric fluid.

7. The arrangement according to claim 1, wherein the heat pipe extends between a first end (16a) and a second end (16b),
wherein the first end of the heat pipe is embedded in the thermally conductive block; and
wherein the second end of the heat pipe comprises a set of fins (17a, 17b, 17c) for heat transfer to the dielectric fluid.

8. The arrangement according to claim 1, further comprising
a further thermally conductive block (13d, 13e, 13f), the further thermally conductive block being provided in the tank and in thermal contact with a wall of the tank; and
wherein the heat pipe extends between a first end and a second end,
wherein the first end of the heat pipe is embedded in the thermally conductive block, and
wherein the second end of the heat pipe is embedded in the further thermally conductive block for heat transfer to the wall.

9. The arrangement according to claim 1, further comprising
at least one further heat pipe (15b, 15c), each of the at least one further heat pipe being at least partly embedded in a respective thermally conductive block (13b, 13c) so as to transfer heat away from its respective thermally conductive block.

10. The arrangement according to claim 1, further comprising
an electrically insulating plate (24), the electrically insulating plate being sandwiched between the thermally conductive block and the semiconductor module.

11. The arrangement according to claim 1, wherein the semiconductor module is part of a power electronics building block.

12. The arrangement according to claim 1, wherein the dielectric fluid is pressurized to a pressure closer to ambient sea water pressure than to atmospheric pressure.

13. The arrangement according to claim 1, wherein the tank is a water-sealed tank.

14. A subsea power conversion unit (28) comprising an arrangement according to claim 1.

15. A method for subsea cooling of a semiconductor module (11), the method comprising:
providing (S102) a tank (12) filled with a dielectric fluid (14), the dielectric fluid being a liquid;
providing (S104) a semiconductor module (11) in the tank; **characterized by**
providing (S106) a thermally conductive block (13a) in the tank to be in thermal contact with the semiconductor module so as to enable heat to be transferred from the semiconductor module to the thermally conductive block;
providing (S108) a heat pipe (15a) at least partly embedded in the thermally conductive block; and
cooling (S110) the semiconductor module (11) by transferring heat away from the thermally conductive block through the heat pipe.

## Patentansprüche

1. Anordnung (10a, 10b, 10c, 10d, 10e, 10f, 10g) für eine Unterwasserkühlung eines Halbleitermoduls (11), wobei die Anordnung umfasst:
einen Tank (12), wobei der Tank mit einem dielektrischen Fluid (14) gefüllt ist, wobei das dielektrische Fluid eine Flüssigkeit ist;
ein Halbleitermodul (11), wobei das Halbleitermodul in dem Tank bereitgestellt wird; **gekennzeichnet durch**:
einen thermisch leitfähigen Block (13a), wobei der thermisch leitfähige Block in dem Tank und in einem thermischen Kontakt mit dem Halbleitermodul bereitgestellt wird, um zu ermöglichen, dass Wärme von dem Halbleitermodul auf den thermisch leitfähigen Block übertragen wird; und
ein Wärmerohr (15a), wobei das Wärmerohr mindestens teilweise in den thermisch leitfähigen Block eingebettet ist, um Wärme aus dem thermisch leitfähigen Block hinaus zu übertragen.

2. Anordnung nach Anspruch 1, wobei sich das Wärmerohr zwischen einem ersten Ende (16a) und einem zweiten Ende (16b) erstreckt und
wobei das erste Ende und das zweite Ende in dem thermisch leitfähigen Block hermetisch abgeschlossen sind.

3. Anordnung nach Anspruch 1, wobei der thermisch leitfähige Block einen ersten Abschnitt (19a) und einen zweiten Abschnitt (19b) aufweist,
wobei der erste Abschnitt des thermisch leitfähigen Blocks so angeordnet ist, dass er in einem thermischen Kontakt mit dem Halbleitermodul steht und dass er Wärme von dem Halbleitermodul empfängt; und
wobei der zweite Abschnitt des thermisch leitfähigen Blocks so angeordnet ist, dass er in einem thermischen Kontakt mit dem dielektrischen Fluid steht, um Wärme auf das dielektrische Fluid zu übertragen.

4. Anordnung nach Anspruch 3,
wobei der zweite Abschnitt des thermisch leitfähigen Blocks eine ausgedehnte Oberfläche zum Übertragen von Wärme auf das dielektrische Fluid aufweist.

5. Anordnung nach Anspruch 4,
wobei die ausgedehnte Oberfläche eine Gruppe von Lamellen (17a, 17b, 17c) umfasst.

6. Anordnung nach Anspruch 1, die außerdem eine Wärmesenke (18a, 18b) umfasst; und
wobei sich das Wärmerohr zwischen einem ersten Ende (16a) und einem zweiten Ende (16b) erstreckt,
wobei das erste Ende des Wärmerohrs in den thermisch leitfähigen Block eingebettet ist und
wobei das zweite Ende des Wärmerohrs für eine Wärmeübertragung auf das dielektrische Fluid in die Wärmesenke eingebettet ist.

7. Anordnung nach Anspruch 1,
wobei sich das Wärmerohr zwischen einem ersten Ende (16a) und einem zweiten Ende (16b) erstreckt,
wobei das erste Ende des Wärmerohrs in den thermisch leitfähigen Block eingebettet ist; und
wobei das zweite Ende des Wärmerohrs eine Gruppe von Lamellen (17a, 17b, 17c) für eine Wärmeübertragung auf das dielektrische Fluid umfasst.

8. Anordnung nach Anspruch 1, die außerdem
einen weiteren thermisch leitfähigen Block (13d, 13e, 13f) umfasst, wobei der weitere thermisch leitfähige Block in dem Tank und in einem thermischen Kontakt mit einer Wand des Tanks bereitgestellt wird; und
wobei sich das Wärmerohr zwischen einem ersten Ende und einem zweiten Ende erstreckt,
wobei das erste Ende des Wärmerohrs in den thermisch leitfähigen Block eingebettet ist und
wobei das zweite Ende des Wärmerohrs für eine Wärmeübertragung auf die Wand in den weiteren thermisch leitfähigen Block eingebettet ist.

9. Anordnung nach Anspruch 1, die außerdem mindestens ein weiteres Wärmerohr (15b, 15c) umfasst, wobei jedes des mindestens einen weiteren Wärmerohrs mindestens teilweise in einen jeweiligen thermisch leitfähigen Block (13b, 13c) eingebettet ist, um Wärme aus dem jeweiligen thermisch leitfähigen Block hinaus zu übertragen.

10. Anordnung nach Anspruch 1, die außerdem eine elektrisch isolierende Platte (24) umfasst, wobei die elektrisch isolierende Platte zwischen den thermisch leitfähigen Block und das Halbleitermodul eingeklemmt ist.

11. Anordnung nach Anspruch 1, wobei das Halbleitermodul Teil eines Leistungselektronikbausteins ist.

12. Anordnung nach Anspruch 1, wobei das dielektrische Fluid auf einen Druck komprimiert wird, der näher bei dem umgebenden Seewasserdruck als bei dem Atmosphärendruck liegt.

13. Anordnung nach Anspruch 1, wobei der Tank ein wasserdichter Tank ist.

14. Unterwasserstromwandlereinheit (28), die eine Anordnung nach Anspruch 1 umfasst.

15. Verfahren für eine Unterwasserkühlung eines Halbleitermoduls (11) wobei das Verfahren umfasst:
Bereitstellen (S102) eines Tank (12), der mit einem dielektrischen Fluid (14) gefüllt ist, wobei das dielektrische Fluid eine Flüssigkeit ist;
Bereitstellen eines (S104) Halbleitermoduls (11) in dem Tank;
**gekennzeichnet durch**:
Bereitstellen (S106) in dem Tank eines thermisch leitfähigen Blocks (13a), der in einem thermischen Kontakt mit dem Halbleitermodul steht, um zu ermöglichen, dass Wärme von dem Halbleitermodul auf den thermisch leitfähigen Block übertragen wird;
Bereitstellen (S108) eines Wärmerohrs (15a), das mindestens teilweise in den thermisch leitfähigen Block eingebettet ist; und
Kühlen (S110) des Halbleitermoduls (11), indem Wärme durch das Wärmerohr aus dem thermisch leitfähigen Block hinaus übertragen wird.

## Revendications

1. Agencement (10a, 10b, 10c, 10d, 10e, 10f, 10g) pour le refroidissement sous-marin d'un module semi-conducteur (11), l'agencement comprenant :
un réservoir (12), le réservoir étant rempli avec un fluide diélectrique (14), le fluide diélectrique étant un liquide ;
un module semi-conducteur (11), le module semi-conducteur étant prévu dans le réservoir ; **caractérisé par**
un bloc thermiquement conducteur (13a), le bloc thermiquement conducteur étant prévu dans le réservoir et en contact thermique avec le module semi-conducteur afin de permettre à de la chaleur d'être transférée du module semi-conducteur au bloc thermiquement conducteur ; et
un tuyau à chaleur (15a), le tuyau à chaleur étant au moins partiellement incorporé dans le bloc thermiquement conducteur afin de transférer de la chaleur pour l'éloigner du bloc thermiquement conducteur.

2. Agencement selon la revendication 1, dans lequel le tuyau à chaleur s'étend entre une première extrémité (16a) et une seconde extrémité (16b), et
dans lequel la première extrémité et la seconde extrémité sont hermétiquement fermées dans le bloc thermiquement conducteur.

3. Agencement selon la revendication 1, dans lequel le bloc thermiquement conducteur a une première portion (19a) et une seconde portion (19b),
dans lequel la première portion du bloc thermiquement conducteur est agencée pour être en contact thermique avec le module semi-conducteur et pour recevoir de la chaleur à partir du module semi-conducteur ; et
dans lequel la seconde portion du bloc thermiquement conducteur est agencée pour être en contact thermique avec le fluide diélectrique afin de transférer de la chaleur au fluide diélectrique.

4. Agencement selon la revendication 3,
dans lequel la seconde portion du bloc thermiquement conducteur a une surface étendue pour transférer de la chaleur au fluide diélectrique.

5. Agencement selon la revendication 4,
dans lequel la surface étendue comprend un ensemble d'ailettes (17a, 17b, 17c).

6. Agencement selon la revendication 1, comprenant en outre un dissipateur de chaleur (18a, 18b) ; et
dans lequel le tuyau à chaleur s'étend entre une première extrémité (16a) et une seconde extrémité (16b),
dans lequel la première extrémité du tuyau à chaleur est incorporée dans le bloc thermiquement conducteur, et
dans lequel la seconde extrémité du tuyau à chaleur est incorporée dans le dissipateur de chaleur pour le transfert de chaleur au fluide diélectrique.

7. Agencement selon la revendication 1, dans lequel le tuyau à chaleur s'étend entre une première extrémité (16a) et une seconde extrémité (16b),
dans lequel la première extrémité du tuyau à chaleur est incorporée dans le bloc thermiquement conducteur ; et
dans lequel la seconde extrémité du tuyau à chaleur comprend un ensemble d'ailettes (17a, 17b, 17c) pour le transfert de chaleur au fluide diélectrique.

8. Agencement selon la revendication 1, comprenant en outre
un bloc thermiquement conducteur supplémentaire (13d, 13e, 13f), le bloc thermiquement conducteur supplémentaire étant prévu dans le réservoir et en contact thermique avec une paroi du réservoir ; et
dans lequel le tuyau à chaleur s'étend entre une première extrémité et une seconde extrémité,
dans lequel la première extrémité du tuyau à chaleur est incorporée dans le bloc thermiquement conducteur, et dans lequel la seconde extrémité du tuyau à chaleur est incorporée dans le bloc thermiquement conducteur supplémentaire pour le transfert de chaleur à la paroi.

9. Agencement selon la revendication 1, comprenant en outre au moins un tuyau à chaleur supplémentaire (15b, 15c), chacun de l'au moins un tuyau à chaleur supplémentaire étant au moins partiellement incorporé dans un bloc thermiquement conducteur respectif (13b, 13c) afin de transférer de la chaleur pour l'éloigner de son bloc thermiquement conducteur respectif.

10. Agencement selon la revendication 1, comprenant en outre une plaque électriquement isolante (24), la plaque électriquement isolante étant prise en sandwich entre le bloc thermiquement conducteur et le module semi-conducteur.

11. Agencement selon la revendication 1, dans lequel le module semi-conducteur fait partie d'un bloc de construction électronique de puissance.

12. Agencement selon la revendication 1, dans lequel le fluide diélectrique est mis sous pression jusqu'à une pression plus proche d'une pression d'eau de mer ambiante qu'une pression atmosphérique.

13. Agencement selon la revendication 1, dans lequel le réservoir est un réservoir étanche à l'eau.

14. Unité de conversion de puissance sous-marine (28) comprenant un agencement selon la revendication 1.

15. Procédé pour le refroidissement sous-marin d'un module semi-conducteur (11), le procédé comprenant :
la fourniture (S102) d'un réservoir (12) rempli avec un fluide diélectrique (14), le fluide diélectrique étant un liquide ;
la fourniture (S104) d'un module semi-conducteur (11) dans le réservoir ;
**caractérisé par**
la fourniture (S106) d'un bloc thermiquement conducteur (13a) dans le réservoir pour être en contact thermique avec le module semi-conducteur afin de permettre à de la chaleur d'être transférée du module semi-conducteur au bloc thermiquement conducteur ;
la fourniture (S108) d'un tuyau à chaleur (15a) au moins partiellement incorporé dans le bloc thermiquement conducteur ; et
le refroidissement (S110) du module semi-conducteur (11) en transférant de la chaleur pour l'éloigner du bloc thermiquement conducteur par l'intermédiaire du tuyau à chaleur.
